# EUROPÄISCHE PATENTANMELDUNG

(11) **EP 1 164 634 A2**
(43) Veröffentlichungstag der Anmeldung: **19.12.2001**
(21) Anmeldenummer: 01114016.7
(22) Anmeldetag: 08.06.2001
(51) Int. Cl.: H01L 21/336, H01L 21/8242

(54) **Verfahren zur Herstellung eines Feldeffekttransistors**

(30) Priorität: 16.06.2000 DE 10029659
(71) Anmelder: Infineon Technologies AG, 81669 München (DE)
(72) Erfinder: Curello, Giuseppe, Dr., 01109 Dresden (DE); Kieslich, Albrecht, Dr., 01445 Radebeul (DE)
(74) Vertreter: Ginzel, Christian

(57) **Zusammenfassung**

Es wird ein Verfahren zur Herstellung von Feldeffekttransistoren mit reduzierter pn-Übergangskapazität zwischen Source und/oder Drain und dem Substrat durch Hinzufügen eines zusätzlichen Implantationsschrittes mit hoher Energie und kleiner Dosis bereitgestellt. Die reduzierte pn-Übergangskapazität beschleunigt die Schaltgeschwindigkeit eines Transistors. Beschriebenes Verfahren ist dabei leicht in bestehende Herstellungsverfahren von Feldeffekttransistoren zu integrieren.

## Beschreibung

Die vorliegende Erfindung betrifft ein Verfahren zur Herstellung eines Feldeffekttransistors. Die vorliegende Erfindung betrifft insbesondere ein Verfahren zur Herstellung von MOS-Feldeffekttransistoren für integrierte Schaltungen, insbesondere DRAM- und embedded DRAM-Bauelemente.

Auf dem Weg zu immer schnelleren, hochintegrierten elektronischen Schaltungen kommt es zunehmend darauf an, die von den Transistoren verursachten Verzögerungen zu minimieren. Dies gilt sowohl für analoge Schaltungen als auch für digitale Schaltungen und Speicher-Bausteine, die meist Feldeffekttransistoren und insbesondere MOS- oder CMOS-Feldeffekttransistoren aufweisen.

Die Schaltgeschwindigkeit von Feldeffekttransistoren ist dabei im wesentlichen durch das Produkt der Lastkapazität des Transistors (C_{L}), die beim Schalten aufgeladen werden muß, mit der Versorgungsspannung (V_{dd}) geteilt durch den Strom I_{d}, der zum Aufladen verwendet wird, bestimmt. Die Lastkapazität C_{L} setzt sich dabei aus mehreren parasitären Kapazitäten zusammen, die je nach der Bauart des Transistors unterschiedlich stark zu der Lastkapazität betragen. Wichtige Beiträge zur Lastkapazität sind in der Regel die Kapazität des Gates zum Substrat (C_{g}), die Kapazität zwischen Gate und Drain (Cₒᵥₗ), die Kapazität des pn-Übergangs von Drain und/oder Source zum Substrat (Cⱼ) sowie die Kapazität (Cᵢ), die durch die Kontakte bedingt sind.

Um die Verzögerungen beim Schalten von Feldeffekttransistoren gering zu halten, werden nach dem Stand vielfältige Maßnahmen ergriffen. Zum einen wird versucht, einen möglichst großen Strom I_{d} bereitzustellen, so dass die Kapazitäten schneller aufgeladen werden können. Weiterhin werden die Source/Drain-Gebiete möglichst hoch dotiert, um den Widerstand von Drain und Source möglichst klein zu haben.

Weitere Maßnahmen bestehen darin, die parasitären Kapazitäten eines Feldeffekttransistors so gering wie möglich zu gestalten. Dies geschieht in der Regel dadurch, dass die Gate-Breite eines Feldeffekttransistors zunehmend reduziert wird, wodurch sich C_{g} verkleinert. Jedoch sind die genannten Maßnahmen weitgehend ausgereizt, so dass sich auf diesem Wege nur noch mit einem hohen Aufwand eine weitere Reduzierung der Schaltverzögerungen erzielen läßt.

Der Erfindung liegt daher die Aufgabe zugrunde, ein einfaches und kostengünstiges Verfahren zur Herstellung eines Feldeffekttransistors mit erhöhter Schaltgeschwindigkeit bereitzustellen.

Diese Aufgabe wird von dem Verfahren zur Herstellung eines Feldeffekttransistors gemäß des unabhängigen Patentanspruchs 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Herstellung eines Feldeffekttransistors bereitgestellt, das die folgenden Schritten aufweist:
a) ein Substrat, das eine Oberflächenschicht aus einem Material eines ersten Leitungstyps aufweist, wird bereitgestellt;
b) ein Gateoxid wird erzeugt;
c) eine Gate-Elektrode wird aufgebracht;
d) ein erster Implantationsschritt zur Erzeugung der Source/Drain-Gebiete wird mit einem Dotierungsmaterial des zweiten Leitungstyps, mit einer ersten Energie und einer ersten Dosis durchgeführt; und
e) ein zweiter Implantationsschritt wird mit einem Dotierungsmaterial des zweiten Leitungstyps, mit einer zweiten Energie und einer zweiten Dosis durchgeführt, wobei die zweite Energie größer als die erste Energie und die zweite Dosis kleiner als die erste Dosis ist, so dass die Kapazität des pn-Übergangs vom Source/Drain-Gebiet zu dem Substrat verringert wird

Der erste Implantationsschritt bezeichnet die Implantation, die im wesentlichen die Leitfähigkeit von Source und/oder Drain bestimmt. Sie ist die Implantation mit der höchsten Dosis im Source und/oder Drain-Gebiet. Sie muß nicht notwendig die erste Implantation zur Herstellung eines Feldeffekttransistors oder zur Herstellung von Drain und/oder Source eines Feldeffekttransistors sein. Mit erstem Implantationsschritt sind daher nicht Implantationen gemeint, die z.B. eine korrigierende Funktion in dem Source und/oder Drain-Gebiet ausüben, wie z.B. die Lightly-Doped-Drain (LDD)-Implantation, welche die elektrischen Feldspitzen am Rand des Drain-Gebiets reduzieren.

Das Dotierungsmaterial des ersten Implantationsschrittes kann aus allen Materialien bestehen, die bzgl. des Substrats den jeweils anderen Leitungstyp erzeugen; insbesondere also Bor, wenn das Substrat ein n-Leitungstyp ist oder Phosphor und/oder Arsen, wenn das Substrat ein p-Leitungstyp ist. Die Energie, mit der die ionisierten Dotierungsatome oder Moleküle auf die Oberflächenschicht zu beschleunigt werden, bestimmt die Tiefe des Dotierungsprofilmaximums und Form des Dotierungsprofils. Der Implantation folgt normalerweise ein Wärmebehandlung, so dass die Dotierungsatome weiter in das Substrat diffundieren und sie im Gitter als Elektronen-Donatoren oder Elektronen-Akzeptoren aktiviert werden.

Die erste Energie und die erste Dosis beziehen sich auf die Beschleunigungsenergie und Dosis im ersten Implantationsschritt. Da die erste Dosis die größte von möglicherweise mehreren Source und/oder Drain-Implantationen ist, bestimmt sie im allgemeinen den Schichtwiderstand an der Oberfläche von Source und/oder Drain.

Der zweite Implantationsschritt erfolgt mit Dotierungsmaterialien des gleichen Leitungstyps wie im ersten Implantationsschritt, jedoch mit größerer Energie und kleinerer Dosis. Ziel dieses Implantationsschrittes ist es, die zum Substratinneren hin abfallende steile Dotierungsprofilflanke durch Überlagerung eines zweiten Dotierungsprofils mit niedrigerer Dosis weniger steil abfallen zu lassen. Auf diese Weise kann ein weicher pn-Übergang (graded junction) zum Substrat hin erzeugt werden, der bei gleicher Spannung eine größere Tiefe der Verarmungszone zwischen Drain/Source und Substrat erzeugt als ein abruptes Dotierungsprofil. Die größere Verarmungszonentiefe reduziert die Kapazität zwischen Drain bzw. Source zum Substrats Cⱼ. Dabei ist es bevorzugt, wenn die Kapazität des pn-Übergangs vom Source/Drain-Gebiet zu dem Substrat um mindestens 3%, bevorzugt mindestens 5%, verringert wird.

Das erfindungsgemäße Verfahren hat den Vorteil, dass aufgrund der größeren Energie und kleineren Dotierung des zweiten Implantationsschrittes sich das Dotierungsprofil des ersten Implantationsschrittes von der Oberfläche bis zum Dotierungsprofilmaximum nur unwesentlich verändert, so dass der Schichtwiderstandswert von Source und Drain und das statische Kennlinienverhalten des Feldeffekttransistors weitgehend erhalten bleiben. Zum Beispiel ist das Short-Channel-Effekt-Verhalten durch den zweiten Implantationsschritt nicht beeinflußt. Auch dadurch ist ein einfacher Einbau des erfindungsgemäßen Verfahrens in eine bestehende Prozessierungslinie gewährleistet.

Die pn-Übergangskapazität, Cⱼ, kann in hochintegrierten logischen Schaltungen bis zu 50% der gesamten parasitären Transistorkapazität ausmachen (siehe IEEE J.Solid State Circuits SC_19, R.J. Bayuns et al., Seite 755, 1984). Dementsprechend kann durch erfindungsgemäße Verfahren auf einfache Weise eine deutliche Reduzierung der Schaltverzögerung eines Feldeffekttransistors erzielt werden.

Bevorzugt werden der erste und zweite Implantationsschritt mit der gleichen Maskierung von Drain und/oder Source durchgeführt, so dass kein zusätzlicher Maskenschritt für den zweiten Implantationsschritt erforderlich ist. Dies ermöglicht die Anwendung des erfindungsgemäßen Verfahrens auch auf einen bestehenden Herstellungsprozeß mit geringem zusätzlichen Arbeitsaufwand. Bevorzugt werden der erste und der zweite Implantationsschritt direkt hintereinander durchgeführt, wobei die Reihenfolge untereinander keine Rolle spielt. Die Hinzunahme des zweiten Implantationsschrittes stellt in diesem Fall nur eine relativ geringfügige Änderung eines bestehenden Herstellungablaufes dar.

In einer bevorzugten Ausführung sind die Dotierungsmaterialien des ersten Implantationschrittes und des zweiten Implantationschrittes gleich. Diese Maßgabe ermöglicht ein einfaches Zusammenlegen des ersten und des zweiten Implantationsschrittes zu einem einzigen Prozeßschritt, wobei zwischendrin zum richtigen Zeitpunkt lediglich die Energie von dem Wert der ersten Energie auf den Wert der zweiten Energie umgestellt werden muß.

Bevorzugt wird das erfindungsgemäße Verfahren für die Herstellung von MOS-Feldeffekttransistoren und speziell für die Herstellung von CMOS-Feldeffekttransistoren, insbesondere für die Herstellung von embedded DRAMs oder DRAMs angewandt.

Die Erfindung wird nachstehend anhand mehrerer Ausführungsbeispiele unter Bezugnahme von Zeichnungen dargestellt:
- Fig. 1 - 8: Erfindungsgemäße Ausführung des Verfahrens zur Herstellung eines n-Kanal- und eines p-Kanal MOS-Feldeffekttransistors.
- Fig. 9 - 13: Implantationsprofile im Drain/Source-Gebiet eines n-Kanal MOSFETs nach Stand der Technik und nach vier verschiedenen erfindungsgemäßen Ausführungen.
- Fig. 14: Vergleich der Schwellenspannungen von n-Kanal MOSFETs nach Stand der Technik und nach vier verschiedenen erfindungsgemäßen Ausführungen für verschiedene Transistor-Kanallängen.

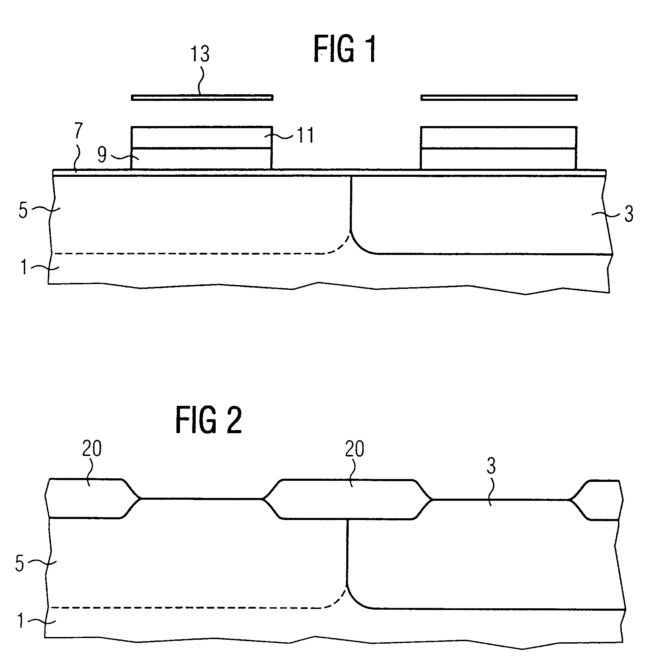

Fig. 1 zeigt ein nach herkömmlichen Verfahren zur Herstellung von hochintegrierten CMOS-Schaltungen (z.B. im 0.4 *µ*m Prozeß) bereitgestelltes Substrat 1 aus leicht p-dotiertem Silizium mit zwei nebeneinanderliegende Gebieten 3 und 5, wobei das Gebiet 3 durch eine n-Implantation mit Phosphor und das Gebiet 5 durch eine p-Implantation mit Bor erzeugt worden ist. Das n-implantierte Gebiet 3 wird im folgenden mit n-Wanne und das p-implantierte Gebiet 5 mit p-Wanne bezeichnet. Durch eine anschließende Wärmebehandlung diffundieren die Dotierungsatome der n-Wanne und der p-Wanne in das Substrat 1, so dass die n- und p-Wannen tiefer in das Substrat hineinreichen als die anschließenden Implantationen für die noch aufzubringenden Transistoren.

Auf die Substratoberfläche ist ferner eine Siliziumoxidschicht 7 aufgewachsen, auf der wiederum eine erste Polysiliziumschicht 9 und eine erste Siliziumnitridschicht 11 aufgebracht ist, die beide auf photolithographischem Wege mit einer ersten Maske 13 strukturiert worden sind. Die Schichten 9 und 11 definieren die Position zweier Feldeffekttransistoren dadurch, dass sie bei der folgenden Oxidation den Transistorbereich abdecken, so dass sich das Feldoxid 20 nur neben den zu erzeugenden Transistoren bilden kann (Fig.2). Anstelle der hier gezeigten sogenannten LOCOS-Isolation kann auch eine sogenannte STI-Isolation (shallow trench isolation) verwendet werden.

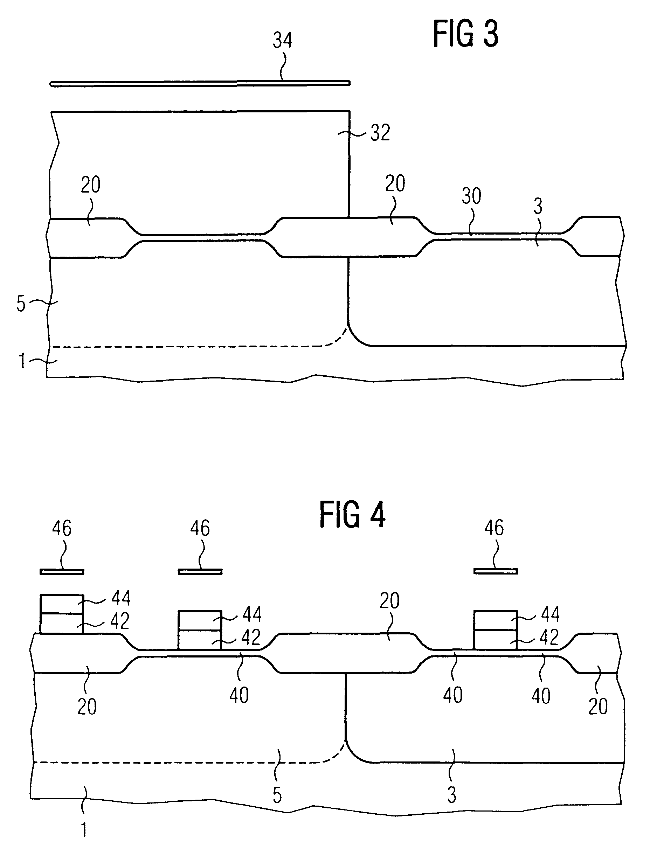

Fig. 3 zeigt das Substrat 1, nachdem eine dünne Streuoxidschicht 30 auf das Substrat aufgewachsen worden ist und mit einer Ionenimplantation ein n-Kanal mit Bor-Atomen für den NMOSFET in der p-Wanne 5 durchgeführt worden ist (Kanaldotierung nicht sichtbar). Die Implantation geht nicht durch das Feldoxid 20 hindurch, das somit als Implantationsmaske wirkt. Auch der offene Bereich in der n-Wanne 3 erhält die n-Implantation. Diese wird jedoch durch eine der folgenden Implantationen wieder kompensiert. Danach wird mittels einer zweiten Maske 34 der p-Wannenbereich 5 mit einem Photoresist 32 abgedeckt. Es folgt eine Ionenimplantation mit Bor für die erforderliche Kanaldotierung für einen p-Kanal MOS-Transistor in der n-Wanne (Kanaldotierung nicht sichtbar).

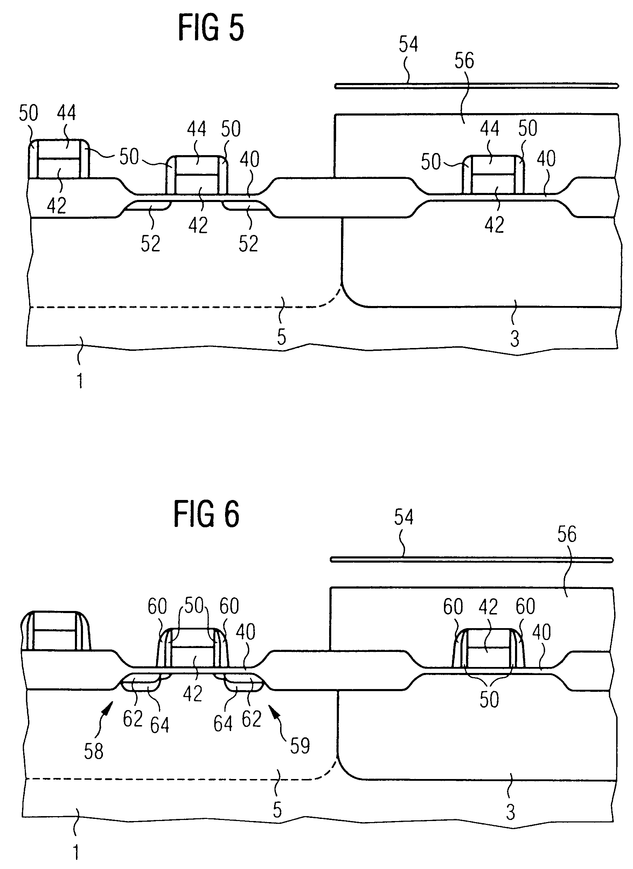

Nach dem Entfernen der Streuoxidschicht 30 wird erst eine Gateoxidschicht für das Gateoxid 40 auf das Substrat gewachsen, dann eine dotierte Polysiliziumschicht für die Gate-Elektrode 42 abgeschieden und eine isolierende Schicht , beispielsweise eine TEOS-Oxidschicht, für die Gate-Abdeckung 44 aufgetragen. Anschließend werden mit einer dritten Maske 46 die TEOS-Oxidschicht und die Polysiliziumschicht strukturiert, so dass ein Gateoxid 40 sowie eine Gate-Elektrode 42 im Sinne des zweiten und dritten Verfahrensschritts des erfindungsgemäßen Verfahrens erzeugt werden (Fig. 4).
Anschließend werden an den Rändern der Gate-Elektroden 42 und Gate-Abdeckung 44 die ersten Siliziumoxid-Spacer 50 erzeugt. Die ersten Siliziumoxid-Spacer 50 sorgen für einen minimalen Abstand zwischen Gate-Kante und Source- bzw. Drain-Implantation und verhindern so übergroße elektrische Felder an den Seiten des Gates. Anschließend wird ein Streuoxid aufgebracht und das Gebiet um die n-Wanne 3 mit einer vierten Maske 54 mittels eines Photoresists 56 selektiv abgedeckt. Das offene Gebiet definiert die n-Kanal Transistorregion. Nun können die LDD-Gebiete 52 mittels Phosphor- oder Arsenimplantation im Gebiet der p-Wanne 5 erzeugt werden. Bevorzugtes Dotierungsmaterial ist Phosphor, das mit einer niedrigen Energie und einer geringen Dosis in das Substrat eingebracht wird (Fig. 5).

Anschließend werden zweite Siliziumoxid-Spacer 60 erzeugt, so dass sich diese an den ersten Siliziumoxid-Spacern 50 anschließen. Wiederum wird die Region über der n-Wanne 3 mittels der vierten Maske 54 abgedeckt. Nun folgen die zwei Implantationsschritte, welche das Source-Gebiet 59 und das Drain-Gebiet 58 definieren (Fig. 6). Der erste und zweite Implantationsschritt werden direkt hintereinander und bevorzugt beide mit Arsen durchgeführt. Der erste Implantationsschritt wird mit einer niedrigeren Energie als der zweite Implantationsschritt durchgeführt. Der zweite Implantationsschritt führt zu einer Implantation 64, die aufgrund der höheren Energie tiefer im Substrat als die Implantation 62 liegt. Beide Konzentrationsprofile überlagert ergeben eine zum Substratinneren hin weich abfallende Flanke. Die zur Substratoberfläche hin abfallende Flanke bleibt unverändert, so dass der Schichtwiderstand an der Oberfläche von Drain und Source durch den zweiten Implantationschritt nicht verändert wird und das statische Transistorverhalten, z.B. Schwellenspannungen und Kennlinien, erhalten bleibt. Dementsprechend kommt es zu einer Reduzierung der Übergangskapazität Cⱼ, ohne dass das statische Verhalten der Transistoren verändert wurde.

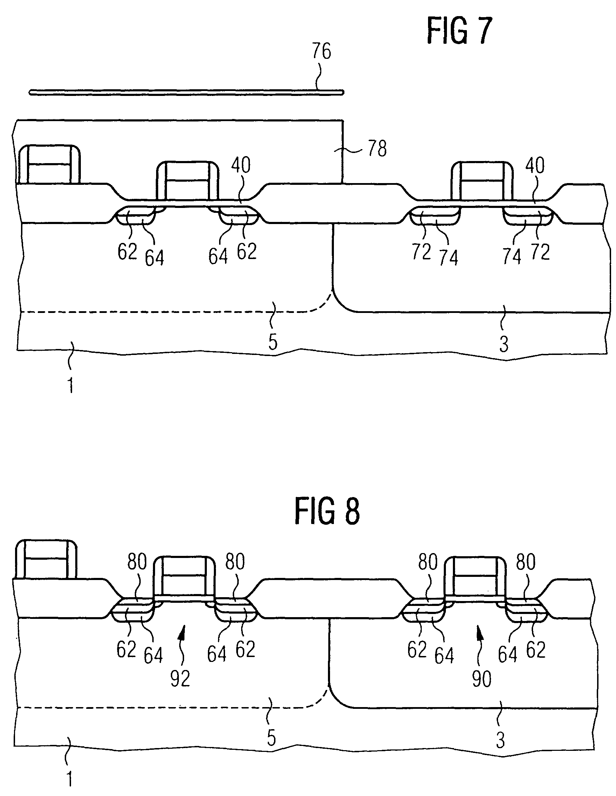

Nachfolgend werden die entsprechenden Implantationen zur Erzeugung des p-Kanal-MOSFETs durchgeführt. Zum Schutz der p-Wannenregion 5 wird ein Photoresist 78 verwendet. Dann folgt der erste Implantationsschritt mit BF₂. Anschließend folgt der zweite Implantationsschritt mit BF₂ bei einer höheren Energie und einer geringeren Dosis, der zu einer zweiten p-Implantation 74 führt. Aufgrund der höheren Energie des zweiten Implantationsschrittes reicht die zweite Implantation tiefer in das Substrat (Fig. 7).

Wie im Falle des n-Kanal MOSFET kann auch hier die Reihenfolge des ersten und zweiten Implantationsschrittes vertauscht werden. Es sei bemerkt, dass der p-Kanal MOSFET im Gegensatz zum n-Kanal MOSFET nicht mit einer LDD-Implantation ausgestattet ist. Nach der Implantation wird der Photoresist 78 abgeätzt und eine Temperung zur Aktivierung der implantierten Boratome durchgeführt.

Zum Anschluß der so hergestellten Feldeffekttransistoren wird nun beispielsweise Titan abgeschieden und getempert, so dass sich ein selbst-alignierendes Silicide (Salicide) 80 über den Drain/Source Regionen bilden kann. Der übrige Teil der Titanschicht wird durch einen Titan-Ätzschritt beseitigt. Schließlich folgt ein weiterer Temperungsschritt für eine optimale Barrierenschichtbildung über der Source/Drain-Region. Damit sind Source- und Drainregionen des P-Kanal Feldeffekttransistors 90 und N-Kanal-Feldeffekttransistor 92 kontaktiert. Es können jedoch auch andere Kontaktierungsverfahren verwendet werden. Der weitere Verlauf zur Herstellung einer integrierten Schaltung mit den erfindungsgemäßen Feldeffekttransistoren erfolgt mit Methoden nach dem Stand der Technik.

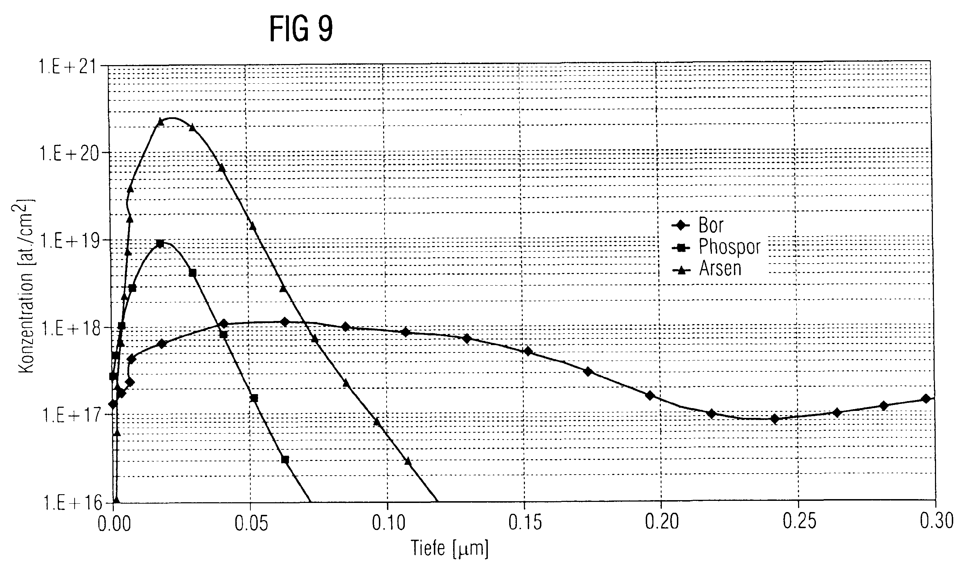

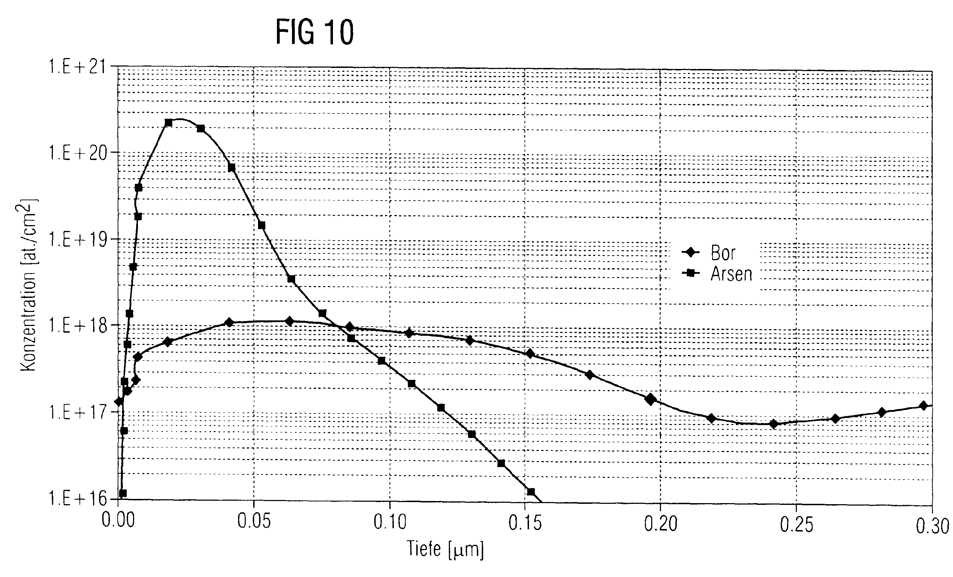

Fig. 9 bis Fig. 13 zeigen die simulierten Dotierungsprofile im Source/Drain-Bereich für eine 0.2 Technologie. Dabei zeigt Fig.9 eine Ausführung ohne zweiten Implantationsschritt, die somit zum Stand der Technik gehört. Die Figuren 10 bis 13 zeigen vier erfindungsgemäße Ausführungen mit verschiedenen zweiten Implantationsschritten.

Fig. 9 zeigt drei Dotierungsprofile im Source/Drain-Gebiet eines n-Kanal-Feldeffekttransistors nach Stand der Technik. Das tiefste Dotierungsprofil ist dabei eine relativ flache Bor-Dotierung mit einer Konzentration von etwa 1*10¹⁷ cm⁻³ bis 1*10¹⁸ cm⁻³. Diese Implantation repräsentiert die p-Wanne des Transistors und reicht bis in eine Tiefe von etwa 200 nm.

In die p-Wanne sind zwei flache Implantationen eingefügt worden: a) eine schwache Dotierung mit Phosphor mit einer Energie von 15 keV und einer Dosis von 2*10¹³ cm⁻², welche die LDD-Region (Lightly-Doped-Drain) definiert. Ihr Maximum liegt in einer Tiefe von etwa 30 nm mit einem Dotierungsprofilmaximum von etwa 1*10¹⁹ cm⁻³. Diese Implantation dient im wesentlichen dazu die Feldstärkenspitzen in der Randregion Draingebiets zu reduzieren. b) Eine starke Dotierung mit Arsen mit einer Energie von 30 keV und einer Dosis von 6*10¹⁴ cm⁻², welche die Drain und/oder Source definiert. Ihr Maximum liegt in einer Tiefe von etwa 35 nm mit einem Maximum des Dotierungsprofils von etwa 3*10²⁰ cm⁻². Durch die Bildung eines Spacers an den Seitenwänden der Gateelektrode sind diese beiden Implantationen zueinander lateral versetzt angeordnet. Die Phosphor-Implantation spielt für die folgenden Erläuterungen keine Rolle. Daher diese Implantation in den Figuren 10 bis 13 nicht mehr gezeigt.

Der pn-Übergang zwischen Drain/Source und Wanne liegt in einer Tiefe von 70 nm bei einer Dotierungskonzentration von etwa 1*10¹⁸ cm⁻³. Die relativ hohe Netto-Dotierungskonzentration in der in der Nähe des pn-Übergangs sorgt für eine kleine Verarmungszone, die eine große Kapazität Cⱼ und damit größere Verzögerungszeiten erzeugt. Die Kapazität Cⱼ beträgt in diesem Fall 1.143 fF/*µ*m², und die Überlappungskapazität, Cₒᵥₗ, beträgt 0.198 fF/*µ*m (siehe Tabelle 1).

Fig. 10 zeigt zwei Dotierungsprofile im Source/Drain-Gebiet eines n-Kanal-Feldeffekttransistors entsprechend einer ersten Ausführungsform der Erfindung. Die Bor-Dotierung für die p-Wanne und der ersten Implantationsschritt entsprechen dem, was im Zusammenhang mit Fig. 9 beschrieben wurden. Der zweite Implantationsschritt ist mit einer zweiten Energie von 90 keV, die größer ist als die erste Energie, und einer zweiten Dosis von 5*10¹² cm⁻², die kleiner ist als die erste Dosis, erzeugt worden. Die größere zweite Energie führt dazu, dass das überlagerte Arsen-Dotierungsprofil zur Substratseite hin schwächer abfällt. Das führt dazu, dass a) der pn-Übergang weicher ist, da die Dotierungsflanken schwächer abfallen und b) der pn-Übergang in größerer Tiefe, d.h. in etwa 80 nm Tiefe liegt. Insbesondere die schwächer abfallende Dotierungsflanke trägt dazu bei, dass die Verarmungszonentiefe im pn-Übergangsbereich größer als in Fig. 9 ist. Das wiederum reduziert die pn-Übergangskapazität von 1.143 fF/*µ*m² auf 1.105 fF/*µ*m², während die Überlappungskapazität, Cₒᵥₗ, sich mit 0.200 fF/*µ*m nur unwesentlich verändert (siehe Tabelle 1).

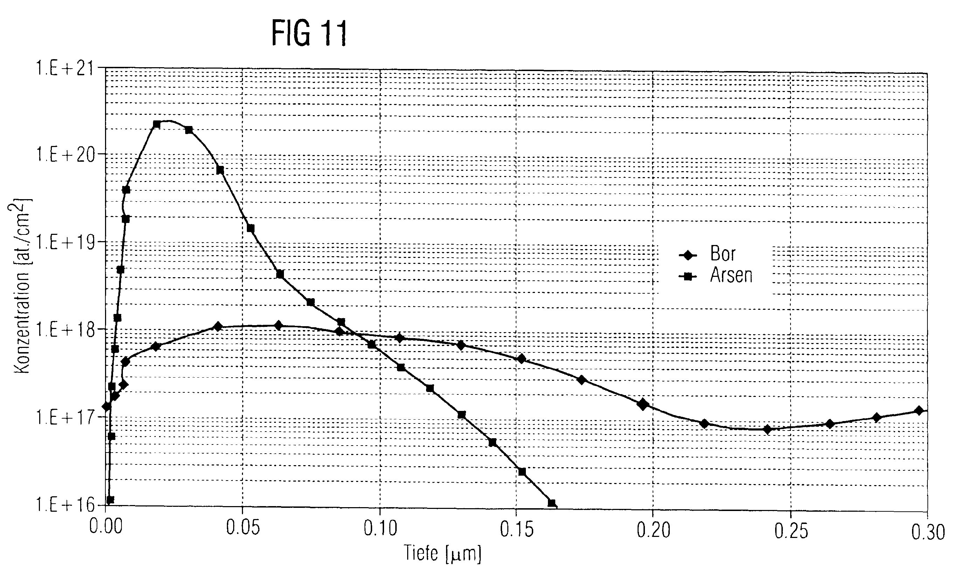

Fig. 11 zeigt die Implantationsprofile nach einer weiteren Ausführung der Erfindung, bei welcher die zweite Implantation mit einer größeren Dosis, d.h. 1*10¹³ cm⁻², durchgeführt worden ist. Dies führt dazu, dass der pn-Übergang in einer Tiefe von 95 nm liegt und die Dotierungsflanke nochmals schwächer zum Substrat hin abfällt. Die pn-Übergangskapazität ist daher nur 1.081 fF/*µ*m², während die Überlappungskapazität, Cₒᵥₗ, sich mit 0.201 fF/*µ*m nur unwesentlich verändert.

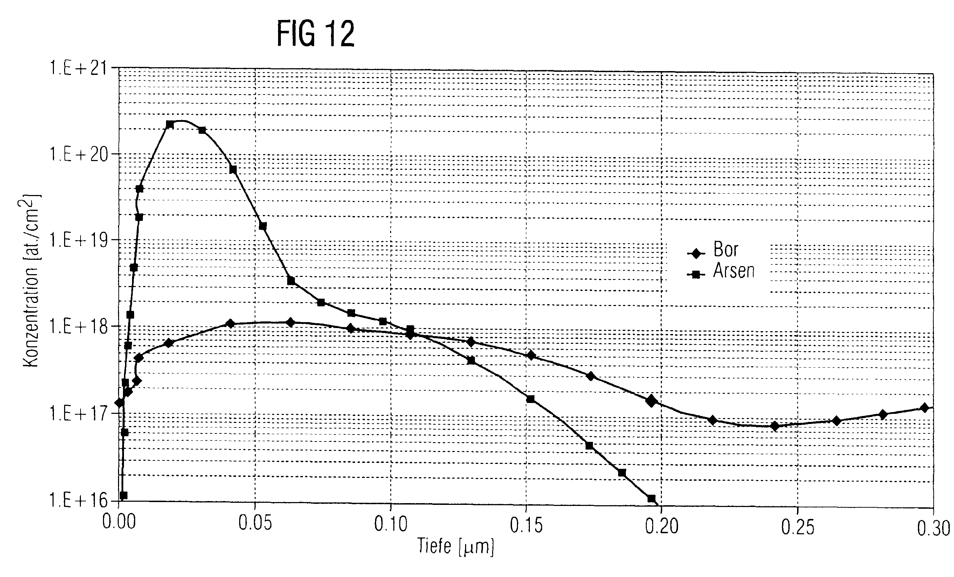

Fig. 12 zeigt die Implantationsprofile nach einer weiteren Ausführung der Erfindung, bei welcher die zweite Implantation mit einer Energie von 120 keV durchgeführt worden ist. Die höhere Energie führt dazu, dass der pn-Übergang in einer Tiefe von 115 nm liegt und die Dotierungsflanke einen relativ weichen Abfall zum Substrat hin aufweist. Die daraus folgende größere Verarmungstiefe führt zu einer Reduzierung der pn-Übergangskapazität auf nur 0.980 fF/*µ*m². Das sind 14% weniger als der gleiche Transistor ohne zweiten Implantationsschritt, während die Überlappungskapazität, Cₒᵥₗ, sich mit 0.209 fF/*µ*m nur unwesentlich verändert.

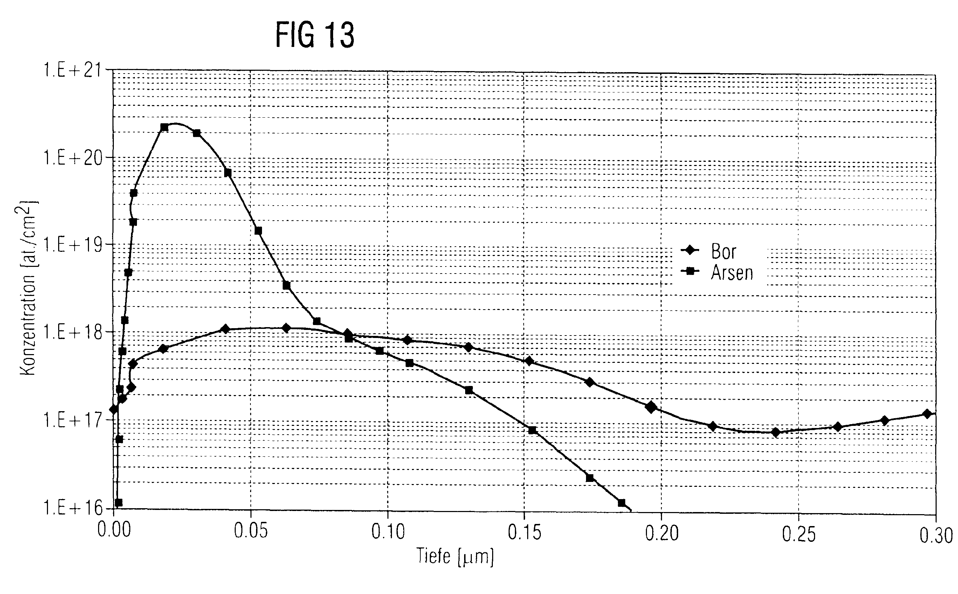

Fig. 13 zeigt die Implantationsprofile nach einer weiteren Ausführung der Erfindung, bei welcher der zweite Implantationsschritt mit einer Dosis von 5*10¹² cm⁻² durchgeführt worden ist. Der pn-Übergang liegt in diesem Fall in einer Tiefe von 80 nm. Dies führt zu einer Reduzierung der pn-Übergangskapazität gegenüber Fig.9 auf 1.042 fF/*µ*m², während die Überlappungskapazität, Cₒᵥₗ, sich mit 0.206 fF/*µ*m nur unwesentlich verändert.

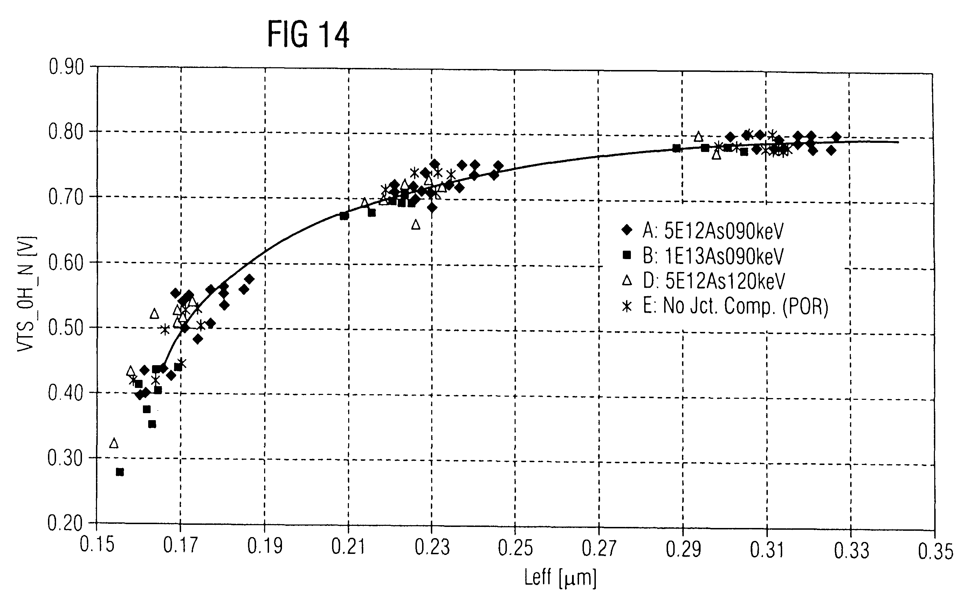

Fig. 14 zeigt eine Untersuchung der Schwellenspannungen von n-Kanal Feldeffekttransistoren, die nach dem Stand der Technik mit Implantationsparametern wie in Fig. 9 und nach erfindungsgemäßen Ausführungen mit Implantationsparametern wie in Fig. 10 bis Fig. 13 hergestellt worden sind. Diese Untersuchungen wurden mit verschiedenen effektiven Transistor-Kanallängen, Leff, zwischen 150 nm und 350 nm durchgeführt. Die Untersuchung zeigt, dass der Abfall der Schwellenspannung bei sehr kurzer effektiver Kanallängen weitestgehend unabhängig davon ist, ob und mit welchen Energien und Dosis' der zweite Implantationsschritt durchgeführt worden ist. Dies ist ein wichtiger Nachweis für Kompatibilität des zweiten Implantationsschrittes mit herkömmlichen Verfahren, so dass das erfindungsgemäße Verfahren ohne großen Aufwand in ein bestehendes Verfahren zur Herstellung von Feldeffekttransistoren verwandt werden kann.

Tabelle 1 vergleicht die Veränderungen der Kapazitäten des pn-Übergangs der beschriebenen, erfindungsgemäßen n-Kanal MOSFETs, wobei die Tabelle auch Werte von erfindungsgemäßen Ausführungen mit p-Kanal Feldeffekttransistoren (p-Kanal MOSFETs) enthält.

**Tabelle 1:**

| (Energie und Dosis für die zweite Implantation) | | | | | | |
|---|---|---|---|---|---|---|
| | Substrat | Implant. | Energie (keV) | Dosis (cm⁻²) | Cⱼ (fF/*µ*m²) | Cₒᵥₗ (fF/*µ*m) |
| NMOS | Bor | As | 0 | 0 | 1.143 | 0.198 |
| NMOS | Bor | As | 90 | 5*10¹² | 1.105 | 0.200 |
| NMOS | Bor | As | 90 | 1*10¹³ | 1.081 | 0.201 |
| NMOS | Bor | As | 120 | 1*10¹³ | 0.980 | 0.209 |
| NMOS | Bor | As | 120 | 5*10¹² | 1.042 | 0.206 |
| PMOS | P | BF₂ | 0 | 0 | 1.427 | 0.263 |
| PMOS | P | BF₂ | 60 | 5*10¹² | 1.361 | 0.266 |
| PMOS | P | BF₂ | 60 | 1*10¹³ | 1.304 | 0.281 |
| PMOS | P | BF₂ | 80 | 1*10¹³ | 1.161 | 0.279 |
| PMOS | P | BF₂ | 80 | 5*10¹² | 1.289 | 0.276 |

### Bezugszeichenliste

- 1: Halbleitersubstrat
- 3: n-Wanne
- 5: p-Wanne
- 7: Siliziumoxid
- 9: Polysiliziumschicht
- 11: Siliziumnitridschicht
- 13: Maske
- 20: Feldoxid
- 30: Streuoxid
- 32: Photoresist
- 34: Maske
- 40: Gateoxid
- 42: Gateelektrode
- 44: TEOS-Oxid
- 46: Maske
- 50: Spacer
- 52: LDD-Gebiet
- 54: Maske
- 56: Photoresist
- 58: Drain-Gebiet
- 59: Source-Gebiet
- 60: Spacer
- 62: Implatation
- 64: Implantation
- 72: Implantation
- 74: Implantation
- 76: Maske
- 78: Photoresist
- 80: Salicide
- 90: p-FET
- 92: n-FET

## Patentansprüche

1. Verfahren zur Herstellung eines Feldeffekttransistors mit den Schritten:
a) ein Substrat, das eine Oberflächenschicht aus einem Material eines ersten Leitungstyps aufweist, wird bereitgestellt;
b) ein Gateoxid wird erzeugt;
c) eine Gate-Elektrode wird aufgebracht;
d) ein erster Implantationsschritt zur Erzeugung der Source/Drain-Gebiete wird mit einem Dotierungsmaterial des zweiten Leitungstyps, mit einer ersten Energie und einer ersten Dosis durchgeführt; und
e) ein zweiter Implantationsschritt wird mit einem Dotierungsmaterial des zweiten Leitungstyps, mit einer zweiten Energie und einer zweiten Dosis durchgeführt, wobei die zweite Energie größer als die erste Energie und die zweite Dosis kleiner als die erste Dosis ist, so dass die Kapazität des pn-Übergangs vom Source/Drain-Gebiet zu dem Substrat verringert wird.

2. Verfahren nach Anspruch 1,
**dadurch gekennzeichnet, dass**
die Kapazität des pn-Übergangs vom Source/Drain-Gebiet zu dem Substrat um mindestens 3%, bevorzugt mindestens 5%, verringert wird.

3. Verfahren nach Anspruch 1 oder 2,
**dadurch gekennzeichnet, dass**
die Maskierung von Drain und/oder Source für den ersten und den zweiten Implantationsschritt gleich ist.

4. Verfahren nach einem der Ansprüche 1 bis 3,
**dadurch gekennzeichnet, dass**
die Dotierungsmaterialien des ersten Implantationsschritts und des zweiten Implantationsschritts gleich sind.

5. Verfahren nach einem der Ansprüche 1 bis 4,
**dadurch gekennzeichnet, dass**
das Verfahren für die Herstellung von integrierten Schaltungen mit CMOS-Feldeffekttransistoren verwandt wird.

6. Verfahren nach Anspruch 5,
**dadurch gekennzeichnet, dass**
die integrierten Schaltungen Embedded DRAM oder DRAMs sind.
